# EUROPEAN PATENT SPECIFICATION

(11) **EP 4 066 059 B1**
(45) Date of publication and mention of the grant of the patent: **28.02.2024**
(21) Application number: 20811609.5
(22) Date of filing: 23.11.2020
(51) Int. Cl.: G03F 7/022, G03F 7/023, G03F 7/039

(54) **CHEMICALLY AMPLIFIED PHOTORESIST**
CHEMISCH VERSTÄRKTER FOTOLACK
RÉSINE PHOTOSENSIBLE AMPLIFIÉE CHIMIQUEMENT

(30) Priority: 25.11.2019 US 201962939741 P
(43) Date of publication of application: 05.10.2022
(73) Proprietor: Merck Patent GmbH, 64293 Darmstadt (DE)
(72) Inventor: KUDO, Takanori, Branchburg, New Jersey 08876 (US); YANG, Fan, Branchburg, New Jersey 08876 (US)
(74) Representative: Rippel, Hans Christoph
(86) International application number: PCT/EP2020/083048
(87) International publication number: WO 2021/105054

(56) References cited:
- EP-A1- 0 962 825
- WO-A1-2018/029142
- US-A1- 2003 134 223
- US-A1- 2005 244 740
- US-A1- 2009 081 589
- US-A1- 2013 330 669

## Description

### FIELD OF INVENTION

The invention pertains to a positive radiation-sensitive aqueous base soluble photoresist composition used for manufacturing integrated circuit (IC), light emitting diode (LED) devices and display devices.

### BACKGROUND

Photoresist compositions are used in microlithographic processes for making miniaturized electronic components such as in the fabrication of computer chips, integrated circuits, light emitting diode (LED) devices and displays. Generally, in these processes, a film of a photoresist composition is first applied to a substrate material, such as silicon wafers used for making integrated circuits. The coated substrate is then baked to evaporate solvent in the photoresist composition and to fix the coating onto the substrate. The baked coated surface of the substrate is next subjected to an image-wise exposure to imaging radiation.

This radiation exposure causes a chemical transformation in the exposed areas of the coated surface. Visible light, ultraviolet (UV) light, electron beam and X-ray radiant energy are imaging radiation types commonly used today in microlithographic processes. After this image-wise exposure, the coated substrate is treated with a developer solution to dissolve and remove either the radiation-exposed or the unexposed areas of the coated surface of the substrate.

The use of a positive-working, sensitive photoresist composition which is developable by aqueous base is known in the prior art. For instance, U.S. Pat. No. 5,069,997 describes radiation sensitive mixtures based on acid cleavable group containing polymeric binder, and an organic compound which upon irradiation forms a strong acid and, whose solubility in an aqueous alkaline developer is increased by the action of acid.

U.S. 2002/0001769 A1 discloses a positive photoresist composition containing an alkali-soluble resin, in which part of phenolic hydroxy groups are protected by an acid-decomposable group, a quinonediazide ester, and a compound which generates an acid upon irradiation of light.

Japanese Patent Laid-Open No. 2008-046594 A2 discloses a positive photoresist composition containing a resin which is a reaction product of a Novolak resin and a polyhydroxystyrene having part of phenolic hydroxy groups are protected by an acid cleavable group, and an acid generator.

Most of the known art pertains to either chemically amplified photoresist based on either phenolic or (meth)acrylate resin, or non-chemically amplified photoresists based on Novolak/diazonaphthoquinone (DNQ). In chemically amplified positive photoresist a base soluble resin, usually a phenolic resin or (meth)acrylate resin, is released in areas of the resist exposed to radiation, rendering it aqueous base developable, by an acid catalyzed cleavage of protecting groups on these resins, originally masking the base solubilizing moieties. In these chemically amplified photoresists, the catalytic acid is formed by photo-decomposition of photo-acid generator (PAG) component. These types of resists are typically employed at shorter wavelengths in quest for higher resolution in the manufacture of IC's.

Conventional Novolak/DNQ resist platform produce sloped profiles, particularly at thicker films due to their high film absorption of irradiation light. Positive chemically amplified platforms, on the other hand can provide adequate performance for film thickness below 10µm, however the polymer used for these resists, are much more expensive than conventional Novolak resins. Also, certain designs for positive chemically amplified resists which require a post exposure bake have a deleteriously effect on device throughput. Cost and device throughput are also issues for applications pertaining to the manufacture of displays. The potential effect on device throughput issue occurs in certain chemically amplified resists in which the protecting group, masking the base solubilizing moiety, have a high activation energy for their cleavage, in order to unmask the base solubilizing moiety. Although, these high activation energy groups are removable catalytically by acid, this removal requires a post exposure bake step, which is time consuming. Further, process temperature of manufacturing display devices has been increasing. For example, substrate temperature increases during implantation of boron or phosphorous into a low temperature polysilicon which is used for a thin film transistor. Photoresist pattern is required to maintain its shape at the process temperature. WO 2018/029142 A1, US 2009/081589 A1, US 2005/244740 A1, US 2013/330669 A1, US 2003/134223 A1 and EP 0 962 825 A1 are documents that illustrate further relevant concepts known in the field.

### NEEDS ADDRESSED AND PROBLEMS SOLVED BY CURRENT INVENTION

One objective of this invention is to provide cost competitive chemically amplified systems which can be employed in the manufacture of displays.

The present invention aims to provide a chemically amplified photoresist composition, which derived film has high thermal stability, high resolution, contrast, and capable of forming a resist pattern without a post exposure bake (PEB). Excluding PEB can increase manufacturing throughput, decrease processing time and reduce the possibility of deleterious post exposure delay effects such as formation of features having a large extent of T-topping. Although not bound by theory, a PEB is not required, because the low activation energy protecting groups assuring that the resist film in exposed areas is fully deprotected during the exposure phase. Since the protecting groups undergo deprotection during exposure, there is no time lag between generation of photo-acid from a photoacid generator (PAG) and reaction of this photo-acid to deprotect the protecting group. This deprotection during exposure may decrease the opportunity for airborne contaminant to consume photo-acid at exposed resist surfaces, avoiding post-exposure delay effects resulting in severe T-topping of imaged resist features. This is an important problem to solve as severe T-topping of imaged resist features can affect device yield.

### SUMMARY OF THE INVENTION

The present invention provides a chemically amplified resist composition as defined in claim 1.

The present invention provides a process for imaging a resist comprising the steps;
i) coating the above-described composition above a substrate to form a resist film;
ii) selectively exposing said resist film to light using a mask to form a selectively exposed resist film;
iii) developing said selectively exposed film to form a positively imaged resist film over said substrate.

The present invention provides a method for manufacturing a device, comprising the above-described manufacturing method of imaging a resist on a substrate. The present invention provides the use of the chemically amplified resist composition described above for coating a substrate.

### BRIEF DESCRIPTION OF THE DRAWINGS

The accompanying drawings, which are included to provide a further understanding of the disclosed subject matter and are incorporated in and constitute a part of this specification, illustrate embodiments of the disclosed subject matter and together with the description serve to explain the principles of the disclosed subject matter. In the drawings:
FIG. 1 illustrates non-limiting examples of DNQ PAC compounds which can be used as a free PAC;
FIG. 2 illustrates non-limiting examples of photoacid generators which generate sulfonic, and other strong acids;
FIG. 3 illustrates non-limiting examples of photoacid generators which generate either HCl or HBr;
FIG. 4 illustrates SEM images obtained with Example 1; and
FIG. 5 illustrates SEM images obtained with Comparative Example 1.

### DEFINITIONS

Unless otherwise stated, the following terms used in the specification and claims shall have the following meanings for this application.

It is to be understood that both the foregoing general description and the following detailed description are illustrative and explanatory, and are not restrictive of the subject matter, as claimed. In this application, the use of the singular includes the plural, the word "a" or "an" means "at least one", and the use of "or" means "and/or", unless specifically stated otherwise. Furthermore, the use of the term "including", as well as other forms such as "includes" and "included", is not limiting. Also, terms such as "element" or "component" encompass both elements and components comprising one unit and elements or components that comprise more than one unit, unless specifically stated otherwise. As used herein, the conjunction "and" is intended to be inclusive and the conjunction "or" is not intended to be exclusive unless otherwise indicated. For example, the phrase "or, alternatively" is intended to be exclusive. As used herein, the term "and/or" refers to any combination of the foregoing elements including using a single element.

In the present specification, when numerical ranges are indicated using "to", "-" or "~", they include both end points, and the units thereof are common. For example, 5 to 25 mol% means 5 mol% or more and 25 mol% or less.

The section headings used herein are for organizational purposes and are not to be construed as limiting the subject matter described.

Herein, the term "linking point," when referring to any of the inventive polymers refers to a branching point to another polymer chain and/or a crosslinking point to another polymer chain, wherein the extent of branching and/or crosslinking is such that the resultant branched and/or crosslinked polymer still has a molecular weight sufficiently low so as to avoid reaching the gel point where the polymer would become insoluble in solvents such as spin-casting solvents.

Herein, unless otherwise indicated, "hydrocarbon" means one including carbon and hydrogen, and optionally including oxygen or nitrogen. The "hydrocarbyl group" means a monovalent or divalent or higher valent hydrocarbon. In the present specification, "aliphatic hydrocarbon group" means a linear, branched or cyclic aliphatic hydrocarbon, and "aliphatic hydrocarbon group" means a monovalent or divalent or higher valent aliphatic hydrocarbon. "Aromatic hydrocarbon group" means a hydrocarbon comprising an aromatic ring which may optionally not only comprise an aliphatic hydrocarbon group as a substituent but also be condensed with an alicycle. "Aromatic hydrocarbon group" means a monovalent or divalent or higher valent aromatic hydrocarbon. These aliphatic hydrocarbon groups and aromatic hydrocarbon groups optionally contain fluorine, oxy, hydroxy, amino, carbonyl, or silyl and the like. Further, "aromatic ring" means a hydrocarbon comprising a conjugated unsaturated ring structure, and the alicycle means a hydrocarbon comprising a ring structure but no conjugated unsaturated ring structure.

"Alkyl" means a group obtained by removing any one hydrogen from a linear or branched, saturated hydrocarbon and includes a linear alkyl and branched alkyl, and the cycloalkyl means a group obtained by removing one hydrogen from a saturated hydrocarbon comprising a cyclic structure and includes a linear or branched alkyl in the cyclic structure as a side chain, if necessary.

"Alkyloxy" (a.k.a. Alkoxy) refers to an alkyl group as defined above on which is attached through an oxy (-O-) moiety (e.g., methoxy, ethoxy, propoxy, butoxy, 1,2-isopropoxy, cyclopentyloxy cyclohexyloxy and the like). These alkyloxy moieties may be substituted or unsubstituted as described below.

"Halo" or "halide" refers to a halogen, F, Cl, Br, I which is linked by one bond to an organic moiety.

"Haloalkyl" refers to a linear, cyclic or branched saturated alkyl group such as defined above in which at least one of the hydrogens has been replaced by a halide selected from the group consisting of F, Cl, Br, I or mixture of these if more than one halo moiety is present. Fluoroalkyls are a specific subgroup of these moieties.

"Fluoroalkyl" refers to a linear, cyclic or branched saturated alkyl group as defined above in which the hydrogens have been replaced by fluorine either partially or fully (e.g., trifluoromethyl, perfluoroethyl, 2,2,2-trifluoroethyl, perfluoroisopropyl, perfluorocyclohexyl and the like). These fluoroalkyl moieties, if not perfluorinated, may be substituted or unsubstituted as described below.

"Fluoroalkyloxy" refers to a fluoroalkyl group as defined above on which is attached through an oxy (-O-) moiety it may be completed fluorinated (a.k.a. perfluorinated) or alternatively partially fluorinated (e.g., trifluoromethyoxy, perfluoroethyloxy, 2,2,2-trifluoroethoxy, perfluorocyclohexyloxy and the like). These fluoroalkyl moieties, if not perfluorinated may, be substituted or unsubstituted as described below.

Herein, "C_{x-y,}" "Cₓ-C_{y}" and "Cₓ" means the number of carbons in the molecule or substituent group. For example, "C₁₋₆ alkyl" means alkyl having 1 to 6 carbons (such as methyl, ethyl, propyl, butyl, pentyl and hexyl). Further, the fluoroalkyl as used in the present specification refers to one in which one or more hydrogen in alkyl is replaced with fluorine, and the fluoroaryl is one in which one or more hydrogen in aryl are replaced with fluorine.

Herein the term "alkylene" means a group obtained by removing any two or more hydrogen from a linear, branched or cyclic saturated hydrocarbon, which has two or more attachment points (e.g., of two attachment points: methylene, ethylene, 1,2-isopropylene, a 1,4-cyclohexylene and the like; of three attachment points 1,1,1-subsituted methane,1,1,2-subsituted ethane, 1,2,4-subsituted cyclohexane and the like). Here again, when designating a possible range of C₁ to C₂₀, as a non-limiting example, this range encompasses linear alkylenes starting with C₁ but only designates branched alkylenes, or cycloalkylene starting with C₃. These alkylene moieties may be substituted or unsubstituted as described below.

The term "mono- alkyleneoxyalkylene" and "oligomeric alkyleneoxyalkylene" encompasses both simple alkyleneoxyalkylene moiety such as ethyleneoxyethylene (-CH₂-CH₂-O-CH₂-CH₂-), propyleneoxypropylene (-CH₂-CH₂-CH₂-O-CH₂-CH₂-CH₂-), and the like, and also oligomeric materials such as tri(ethyleneoxyethylene) (-CH₂-CH₂-O-CH₂-CH₂-O-CH₂-CH₂-), tri(propyleneoxypropylen), (-CH₂-CH₂-CH₂-O-CH₂-CH₂-CH₂-O CH₂-CH₂-CH₂-), and the like.

Herein the term "aryl group" or "aromatic group" means a group obtained by removing any one hydrogen from an aromatic hydrocarbon, which contain C₆ to C₂₄ including phenyl, tolyl, xylyl, naphthyl, anthracyl, biphenyls, bis-phenyls, tris-phenyls and the like. These aryls may further be substituted with any of the appropriate substituents e.g., alkyl, alkoxy, acyl or aryl groups mentioned hereinabove.

The term "Novolak" if used herein without any other modifier of structure, refers to Novolak resins which are soluble in aqueous bases such as tetramethylammonium hydroxide and the like.

Herein the term "arylene" means a hydrocarbon group obtained by removing any two or more hydrogen from an aromatic hydrocarbon, which has two or more attachment points (e.g., 2-5), this moiety may be a single benzene moiety (e.g., two attachment points 1,4-phenylene, 1,3-phenylene and 1,2-phenylene; three attachment points 1,2,4-subsituted benzene, 1,3,5-substituted benzene and the like), a polycyclic aromatic moiety with two attachment points such as derived from naphthalene, anthracene, pyrene and the like, or a multiple benzene rings in a chain which have two attachment point (e.g., biphenylene). In those instances, where the aromatic moiety is a fused aromatic ring, these may be called fused ring arylenes, and more specifically named, for instance, naphthalenylene, anthracenylene, pyrenylene, and the like. Fused ring arylenes may be substituted or unsubstituted as described below, additionally these fused ring arylenes may also contain a hydrocarbon substituent which has two attachment sites on the fused ring forming an additional aliphatic or unsaturated ring forming by attachment to the fused ring a ring having C₅₋₁₀.

Herein, the term "PAG," unless otherwise described, refers to a photoacid generator that can generate acid (a.k.a. photoacid) under deep UV or UV irradiation such as 200-300 nm, i-line, h-line, g-line and/or broadband irradiation. The acid may be a sulfonic acid, HCl, HBr, HAsF₆, and the like.

Herein, the term "PAC" refers to a diazonaphthoquinone component wherein this moiety is further substituted with a sulfonyl moiety (-SO₂-) attached to a phenolic compound through a sulfonate ester (-SO₂-O-) bond. The phenolic compound forming this sulfonate ester bond may be with a phenolic compound substituted with more than one phenolic OH moiety, and consequently, the PAC may be such a phenolic compound wherein more than one of the phenol OH form this sulfonate bond. Non-limiting examples of these free PAC materials are described in "Diazonapthoquinone-based Resist, Ralph Dammel, SPIE, Optical Engineering Press, Volume TT 11, Chapters 2 and 3."

The term "free PAC" refers to a compound in a photoresist formulation not binding to a polymer.

Herein the term "fused aromatic ring" refers to a carbon based polycyclic aromatic compound comprising C₆₋₈ based aromatic rings fused together (e.g., naphthalene, anthracene, and the like). These fused aromatic rings may have a single attachment point to an organic moiety as part of an aryl moiety such as a pendant fused aromatic ring aryl group on a photoacid generator (PAG) or have two attachment points as part of an arylene moiety, such as, for instance, as in spacer in a substituent attached to a PAG. In PAG's, such substituents, along with other substituent that can interact by resonance delocalization, impart greater absorbance at 365 nm and/or broadband radiation and lead to more effective at these wavelengths.

Herein the term "arene" encompasses aromatic hydrocarbon moieties comprising 1 ring or C₆₋₈ based aromatic rings fused together.

Herein the term "heteroarene" refers to an arene which contains 1 or more trivalent or divalent heteroatoms respectively in such a way as to retain its aromaticity. Examples of such hetero atoms are N, O, P, and S. As non-limiting examples, such heteroarenes may contain from 1 to 3 such hetero atoms.

Unless otherwise indicated in the text, the term "substituted" when referring to an aryl, alkyl, alkyloxy, fluoroalkyl, fluoroalkyloxy, fused aromatic ring, arene, heteroarene refers to one of these moieties which also contain with one or more substituents, selected from the group consisting of unsubstituted alkyl, substituted alkyl, unsubstituted aryl, alkyloxyaryl (alkyl-O-aryl), dialkyloxyaryl ((alkyl-O-)₂-aryl), haloaryl, alkyloxy, alkylaryl, haloalkyl, halide, hydroxyl, cyano, nitro, acetyl, alkylcarbonyl, formyl, ethenyl (CH₂=CH-), phenylethenyl (Ph-CH=CH-), arylethenyl (Aryl-CH=CH-), and substituents comprising ethenylenearylene moieties (e.g., Ar(-CH=CH-Ar-)_{z} where z is 1-3. Specific, non-limiting examples of substituted aryl and substituted aryl ethenyl substituent are as follows, wherein 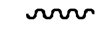 represents the point of attachment: 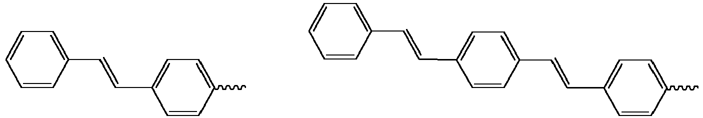 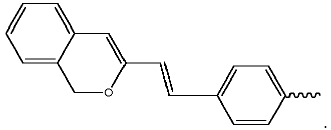 Otherwise, substituted aryl, and substituted ethenyls, where the substituent is selected from any of the above substituents. Similarly, the term "unsubstituted" refers to these same moieties, wherein no substituents apart from hydrogen is present.

The term "quencher system" refers to an assembly of basic components, such as amines, which in a resist formulation could act to capture an acid generated by a photoacid generator during exposure to i-line or broadband radiation.

The term "solid components" refers to components in a photoresist formulation which are not the solvent. Such components may be solids or liquids.

In the present specification, when a polymer comprises plural types of repeating units, these repeating units copolymerize. These copolymerizations can be any of alternating copolymerization, random copolymerization, block copolymerization, graft copolymerization, or any mixture thereof.

In the present specification, "%" represents mass% and "ratio" represents ratio by mass.

In the present specification, the abbreviation "mol%" represents mole %.

In the present specification, Celsius is used as the temperature unit. For example, "20 degrees" means "20 degrees Celsius."

### DETAILED DESCRIPTION

The present invention is described in detail below.

### Chemically Amplified Resist Composition

The chemically amplified resist composition according to the present invention comprises:
(A) a polymer component,
(B) a photoacid generator (PAG),
(C) a photoactive diazonaphthoquinone compound (PAC), and
(D) a solvent.

These components are respectively described below.

### (A) Polymer Component

The present invention relates to the chemically amplified resist composition comprising (A) a polymer component which is a mixture of (A-1) a Novolak derivative and (A-2) a polymer comprising hydroxystyrene repeat units. The polymer component (A) may further comprise an acetal-group-crosslinked copolymer of (A-1) a Novolak derivative and (A-2) a polymer comprising hydroxystyrene repeat units.

The mixture of polymers include (A-1) a Novolak derivative and (A-2) a polymer comprising hydroxystyrene repeat units; wherein
(A-1) a Novolak derivative comprises Novolak repeat units with free phenolic hydroxy moieties and phenolic hydroxy moieties protected with an acid cleavable acetal moiety; and
(A-2) a polymer comprising hydroxystyrene repeat units with free phenolic hydroxy moieties and phenolic hydroxy moieties protected with an acid cleavable acetal moiety.

The crosslinked copolymer has an acetal group linker between (A-1) a Novolak derivative and (A-2) a polymer comprising hydroxystyrene repeat units; wherein
(A-1) a Novolak derivative comprises Novolak repeat units with free phenolic hydroxy moieties and phenolic hydroxy moieties protected with an acid cleavable acetal moiety; and
(A-2) a polymer comprising hydroxystyrene repeat units with free phenolic hydroxy moieties and phenolic hydroxy moieties protected with an acid cleavable acetal moiety.

The acid cleavable acetal moiety of the present invention is preferably a group represented by formula (I): 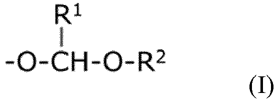 wherein, R¹ and R² represent each independently a C₁₋₄ alkyl.

In the present invention, the polymer component, in which part of phenolic hydroxyl groups is protected by an acid cleavable acetal moiety, can be prepared by any conventional process which is not specifically limited, and for example, can be prepared by the following process. The polymer component is dissolved in an organic solvent, and to the resulting solution, an acid catalyst and an alkylvinyl ether corresponding to the acid cleavable acetal moiety is added; the mixture is allowed to react at a temperature from about 20°C to about 40°C for about 24 hours; the reaction is quenched with a basic compound. After purification, the polymer component, in which part of phenolic hydroxyl groups is protected by an acid cleavable acetal moiety, is obtained.

Typically, from 20 mol% to 31 mol%, preferably 23 mol% to 28 mol%, of the total phenolic hydroxy moieties of the polymer component is protected with the acid cleavable acetal moiety.

### (A-1) Novolak Derivative

A Novolak resin is obtained by condensing a phenolic compound and an aldehyde in the presence of an acid catalyst. Examples of the phenol-based compound used in production of the Novolak resins include, but are not limited to phenol, o- cresol, m- cresol or p-cresol, 2,3- xylenol, 2,5- xylenol, 3,4- xylenol or 3,5-xylenol, 2,3,5-trimethylphenol, 2- tert-butylphenol, 3- tert-butylphenol or 4-tert-butylphenol, 2-tert-butyl-4-methylphenol or 2-tert-butyl-5-methylphenol, 2-ethylphenol, 3- ethylphenol or 4-ethylphenol, 2,5-diethylphenol or 3,5-diethylphenol, 2,3,5-triethylphenol, 2,2-bis(4-hydroxyphenyl)propane, 4,4'-dihydroxydiphenyl ether, bis(4-hydroxyphenyl) sulfone, and the like. These phenol compounds can be used alone or in combination of two or more.

Examples of the aldehyde used in production of the Novolak resin include, but are not limited to, aliphatic aldehydes such as formaldehyde, acetaldehyde, propionaldehyde, n-butylaldehyde, isobutylaldehyde, acrolein or crotonaldehyde; alicyclic aldehydes such as cyclohexanealdehyde, cyclopentanealdehyde, furfural or furylacrolein; aromatic aldehydes such as benzaldehyde, o-methylbenzaldehyde, m-methylbenzaldehyde or p-methylbenzaldehyde, p-ethylbenzaldehyde, 2,4-dimethylbenzaldehyde, 2,5-dimethylbenzaldehyde, 3,4-dimethylbenzaldehyde or 3,5-dimethylbenzaldehyde; aromatic aliphatic aldehydes such as phenylacetaldehyde or cinnamic aldehyde; and the like. These aldehydes can also be used each alone or in combination of two or more. Of these aldehydes, formaldehyde is preferably used.

Preferable Novolak resins are a phenol-formaldehyde Novolak, a cresolformaldehyde Novolak or a xylenol-formaldehyde Novolak having a mass average molecular weight of from 800 to 5,000.

Acid cleavable acetal moiety for protecting part of phenolic hydroxyl groups in the Novolak resin can be any groups that are decomposed or dissociated by reaction of an acid generated from components (B) and (C) described below. The acid cleavable acetal moieties include, but are not limited to, 1-ethoxymethyl, 1-ethoxyethyl, 1-propoxymethyl, 1-propoxyethyl, 1-n-butoxymethyl, 1-iso-butoxymethyl, 1-tert-butoxymethyl, and other alkoxyalkyl. Among them, 1-ethoxyethyl is preferable.

A Novolak derivative, in which part of phenolic hydroxyl groups are protected by an acid cleavable acetal moiety, comprises repeat units represented by formula (II) and (III): 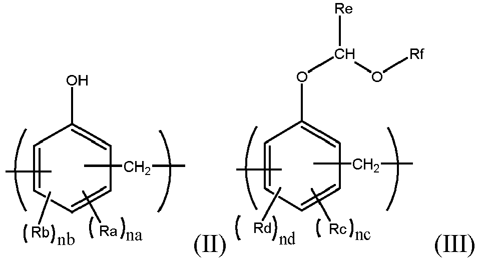 wherein Rₐ, R_{c}, Rₑ and R_{f} are independently a C₁₋₄ alkyl; R_{b} and R_{d} are, independently, a -X-phenol, wherein X is -O-, -C(CH₃)₂-, -(C=O)- or -SO₂-, nₐ and n_{c}, independently, are 0 to 3, n_{b} and n_{d}, independently, are 0 or 1, provided nₐ+n_{b} and n_{d}+n_{c}, respectively, do not exceed 3.

### (A-2) Polymer Comprising Hydroxystyrene

A polymer comprising hydroxystyrene includes, but is not limited to, polymers comprising a unit selected from the group consisting of a 4-hydroxystyrene unit, a 3-hydroxystyrene unit, a 2-hydroxystyrene unit and any mixture thereof, such as 2-vinylphenol (2-hydroxystyrene) homopolymer, 3-vinylphenol (3-hydroxystyrene) homopolymer, 4-vinylphenol (4-hydroxystyrene) homopolymer, 4-isopropenylphenol homopolymer, and copolymers of vinylphenol and copolymerizable comonomer. Such comonomers include, for example, acrylic acid derivatives, methacrylic acid derivatives, styrene, α-methylstyrene, 2-methylstyrene, 3-methylstyrene, 4-methylstyrene, and other styrene derivatives.

The polymer comprising hydroxystyrene can be prepared by standard procedures, typically involving radical polymerization. Copolymerization of two or more monomers yields random copolymers.

Preferable polymers comprising hydroxystyrene are poly(4-hydroxystyrene), poly(3-hydroxystyrene), poly(2-hydroxystyrene), poly(α-methyl-4-hydroxystyrene) or poly(4-hydroxystyrene-co-t-butyl acrylate) having a mass average molecular weight of from 2,000 to 25,000.

Acid cleavable acetal moiety for protecting part of phenolic hydroxyl groups in the polymer comprising hydroxystyrene can be any groups that are decomposed or dissociated by reaction of an acid generated from components (B) and (C) described below. The acid cleavable acetal moieties include, but are not limited to, 1-ethoxymethyl, 1-ethoxyethyl, 1-propoxymethyl, 1-propoxyethyl, 1-n-butoxymethyl, 1-iso-butoxymethyl, 1-tert-butoxymethyl, and other alkoxyalkyl. Among these, 1-ethoxyethyl is preferable.

A polymer comprising hydroxystyrene, in which part of phenolic hydroxyl groups are protected by an acid cleavable acetal moiety, comprises repeat units represented by formula (IV) and (V): 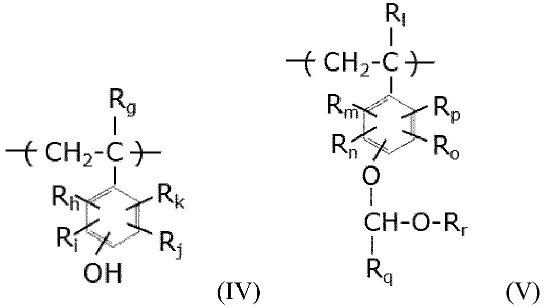 wherein R_{g}, Rₕ, Rᵢ, Rⱼ, Rₖ, Rₗ, Rₘ, Rₙ, Rₒ, and Rₚ are each independently hydrogen or a C₁₋₄ alkyl, R_{q} and Rᵣ are each independently a C₁₋₄ alkyl.

A Novolak derivative and a polymer comprising hydroxystyrene can be crosslinked during a reaction of phenolic hydroxyl groups with alkylvinyl ether. Preferably, a crosslinker is added to the reaction mixture, such as bis(vinyloxy)methane, 1,2-bis(vinyloxy)ethane, 1,4-bis(ethenyloxy)cyclohexane, 1,4-bis[(vinyloxy)methyl]cyclohexane, and the like.

The mass ratio of the Novolak derivative to the polymer comprising hydroxystyrene repeat units is approximately 76:24 to approximately 64:36, preferably approximately 73:27 to approximately 67:33.

The mass ratio of (A) the polymer component to the total mass of the composition is typically approximately 15 to approximately 22 mass %.

### (B) PAG

Said PAG may be selected from the group consisting of aromatic imide N-oxysulfonate derivatives of an organic sulfonic acid, an aromatic sulfonium salt of an organic sulfonic acid and trihalotriazine derivatives. Provided diazonaphthoquinone sulfonate compound is not included in PAG.

For example, more specifically, said PAG can be one which generates, upon 365 nm and/or broadband irradiation, a photoacid such as a sulfonic acid, such as alkylsulfonic acid, aryl sulfonic acid or fluoroalkylsulfonic acid, perfluorosulfonic acid, inorganic acid such as HAsF₆, HSbF₆, HPF6, or acid derived from tetra(perfluorophenyl)borates, H(perf-Ph)₄B, or similar tetra(perfluoroaryl)borates, H(perf-Aryl)₄B. Non limiting examples of such PAGs are such photoacid generator include a variety of photoacid generators, such as onium salts, dicarboximidyl sulfonate esters, oxime sulfonate esters, diazo(sulfonyl methyl) compounds, disulfonyl methylene hydrazine compounds, nitrobenzyl sulfonate esters, biimidazole compounds, diazomethane derivatives, glyoxime derivatives, β-ketosulfone derivatives, disulfone derivatives, sulfonic acid ester derivatives, imidoyl sulfonate derivatives, diazonaphthoquinone sulfonate esters or combinations thereof. Such photoacid generators may inherently be sensitive to 365 nm and/or broadband radiation by appropriate substitution as known in the art. More specifically, these may, for instance, as non-limiting examples, be substituted or unsubstituted triarylsulfonium salt of an organic sulfonic acid, wherein in the triarylsulfonium moiety or its corresponding acid anion contains at least one aryl moiety which has a conjugated aryl, wherein the conjugated aryl moiety is either selected from a phenyl ring with at least one substituent selected from the aryloxy, alkyloxy, nitro, cyano, acetyl, aryl, alkenyl, alkyloxyaryl (alkyl-O-aryl-), dialkyloxyaryl ((alkyl-O-)₂-aryl), or wherein the conjugated aryl moiety, alternatively, is a substituted or unsubstituted fused aromatic ring moiety comprising 2 to 4 rings. Such substituents may be attached through a difunctional moiety capable of undergoing a resonance delocalization, such as arylene, including arylenes derived from a fused aromatic, or for example ethenylene (-C=C-) moieties. ethenyl (CH₂=CH-), phenylethenyl (Ph-CH=CH-), arylethenyl (Aryl-CH=CH-), and substituents comprising ethenylenearylene moieties (e.g. Ar(-CH=CH-Ar-)_{z} where z is 1-3.

Specific, non-limiting examples of substituted aryl and substituted aryl ethenyl substituent are as follows, wherein 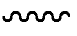 represents the point of attachment:

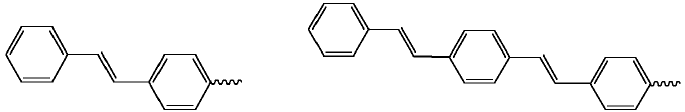

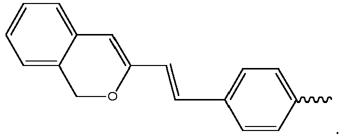

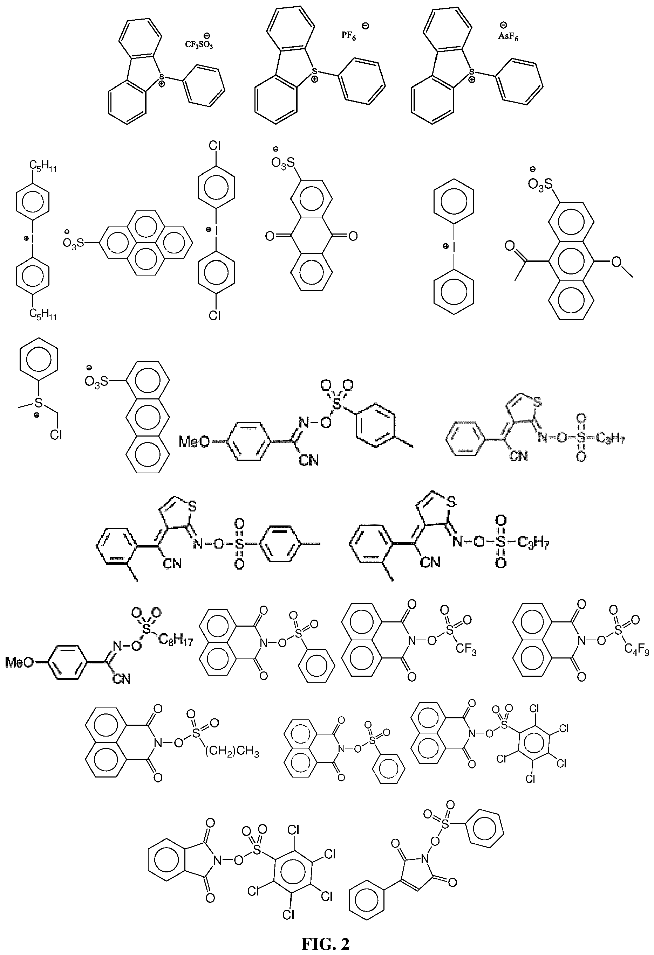

Other examples of common PAGs sensitive to 365 nm and/or broadband radiation are substituted or unsubstituted 1,3-dioxo-1H-benzo[de]isoquinolin-2(3H)-yl ester organic sulfonic acids. FIG. 2 shows non-limiting examples of the above described PAGs. These PAGs may also have substituents as described above.

In this novel composition, said PAG may be one wherein the photoacid generator itself is not directly sensitive to i-line or broadband radiation, but which has been sensitized to this radiation with photosensitizers that extend the effective wavelength and/or energy range. Such photosensitizers may be, without limitation, substituted and unsubstituted anthracenes, substituted and unsubstituted phenothiazines, substituted and unsubstituted perylenes, substituted and unsubstituted pyrenes, and aromatic carbonyl compounds, such as benzophenone and thioxanthone, fluorene, carbazole, indole, benzocarbazole, acridone chlorpromazine, equivalents thereof or combinations of any of the foregoing.

In this invention, said PAG may be a trihalomethyl derivative, and it may be one which contains 1 to 3 trihalomethyl substituents. In the invention, the trihalomethyl derivative may be an arene or substituted arene comprising from 1 to 3 trihalomethyl substituents. Said trihalomethyl derivative may be one which contains 1 to 3 trihalomethyl substituents which are attached to said arene or substituted arene moiety through a sulfone spacer (-SO₂-).

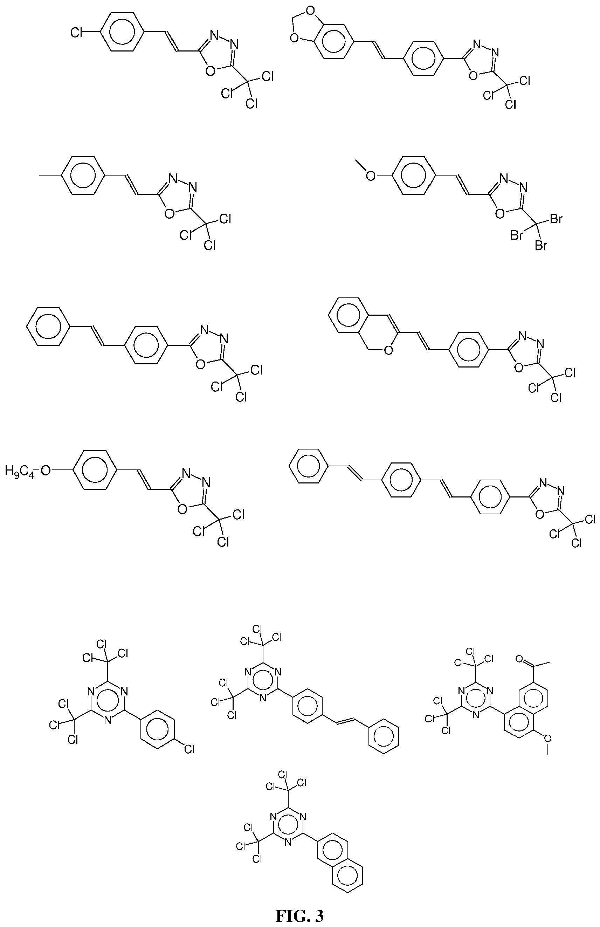

FIG. 3 illustrates non-limiting examples of i-line (broadband) trihalo photoacid generators which generate either HCl or HBr.

In this invention, wherein said PAG is a trihalomethyl, it may be one of a heteroarene or substituted heteroarene comprising 1 to 3 trihalomethyl moieties.

In this invention, wherein said PAG is a trihalomethyl, it may be a derivative of an heteroarene or substituted heteroarene comprising from 1 to 3 trihalomethyl substituents which are attached to said heteroarene or substituted heteroarene through a sulfone spacer (-SO₂-).

In this invention composition it may be any of the above described composition wherein said PAG is at least selected from the group consisting of compounds having structures (VIa), structures (VIb) and structures (VIc); wherein R₁ₚ is a fluoroalkyl moiety, and R₂ₚ is H, an alkyl, an oxyalkyl, a thioalkyl, or an aryl moiety; wherein R₃ₚ is a fluoroalkyl, an alkyl or an aryl moiety, and R₄p is H, an alkyl, an oxyalkyl, a thioalkyl, or an aryl moiety; and further wherein X is Cl or Br, R₅ₚ is an aryl, or an alkyl moiety, and n is 0 or 1:

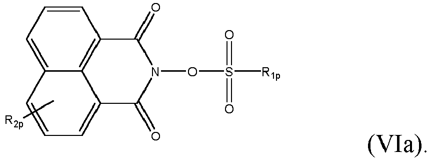

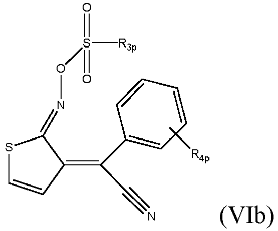

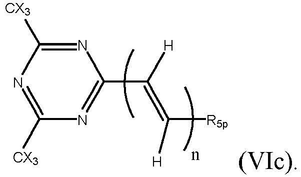

In the inventive composition said PAG may be a trihalomethyl derivative, having structure (VId), wherein R₆ₚ is a substituted or unsubstituted alkenyl or substituted or unsubstituted aryl group, or a substituted or unsubstituted fused aromatic ring moiety comprising 2 to 4 rings and Y is oxygen or nitrogen and X is Cl or Br:

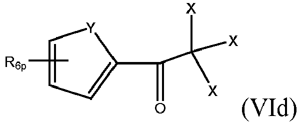

In the inventive composition said PAG may be a trihalomethyl derivative, may be an oxazole or substituted oxazone having structure (VIe), wherein R₇ₚ is a substituted or unsubstituted alkenyl or substituted or unsubstituted aryl group, and X is Cl or Br:

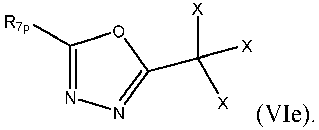

In the inventive composition said PAG may be a trihalomethyl derivative, derivative of a substituted triazine comprising 1 or 2 trihalomethyl moieties.

In the inventive composition said PAG may be a trihalomethyl derivative, it may be a trihalo methyl derivative having structure (VIf), wherein X is Br or Cl and R₈ₚ is an unsubstituted or substituted alkenyl, an unsubstituted aryl or a substituted aryl moiety, or a substituted or unsubstituted fused aromatic ring moiety comprising 2 to 4 rings:

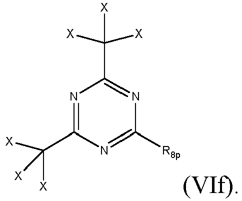

In the inventive composition said PAG may be a trihalomethyl derivative, it may be a derivative having structure (VIg), and R₉ₚ is an unsubstituted or substituted alkenyl or an unsubstituted aryl or substituted aryl moiety:

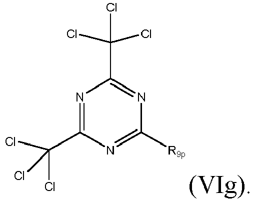

The mass ratio of (B) the photoacid generator to the total mass of the solid components in the composition is typically approximately 1.1 to approximately 1.6 mass %.

**(C) PAC**

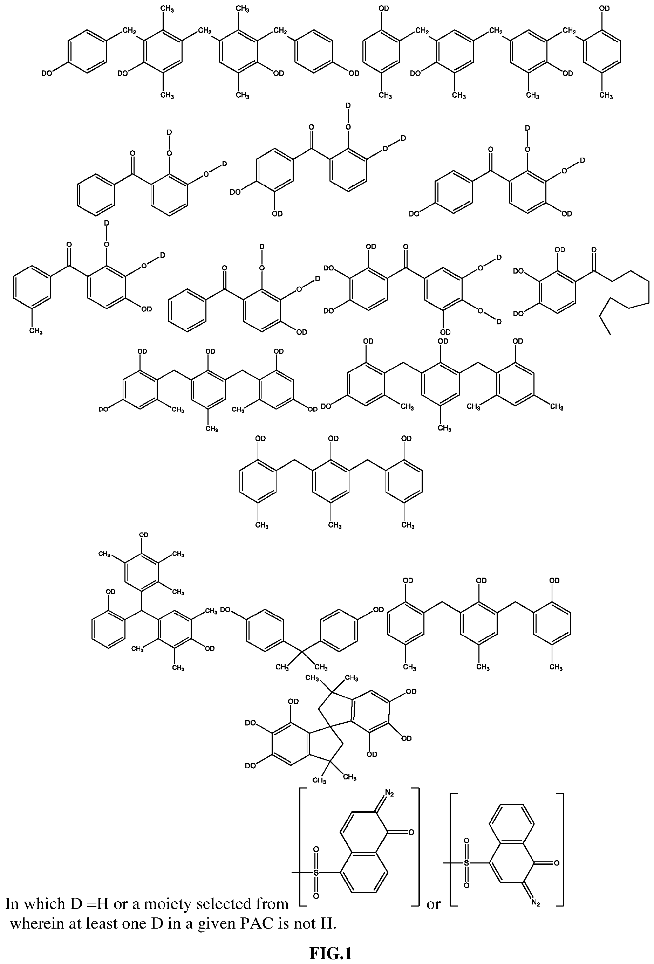

In the above inventive composition, wherein it comprises a free PAC component, this PAC component can be derived from a 1,2-diazonaphthouqinone-5-sulfonate compound or a 1,2-diazonaphthoquinone-4-sulfonate compound. FIG. 1 illustrates non-limiting examples of these types of DNQ PACs, which may be used as free PAC component; wherein FIG. 1, the moiety D is H or a moiety selected from VIIa and VIIb, wherein in each compound depicted in FIG. 1 at least one D is either a moiety of structure VIIa or VIIb:

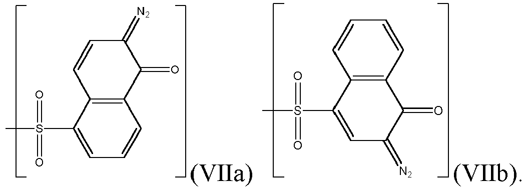

In some embodiments of the above inventive composition, wherein it comprises a free PAC, this PAC is either a single PAC compound or a mixture of PAC compounds having structure (VIII), wherein D_{1c}, D_{2c}, D_{3c}, and D_{4c} are individually selected from H or a moiety having structure (VIIa), and further wherein at least one of D_{1c}, D_{2c}, D_{3c} or D_{4c} is a moiety having structure (VIIa):

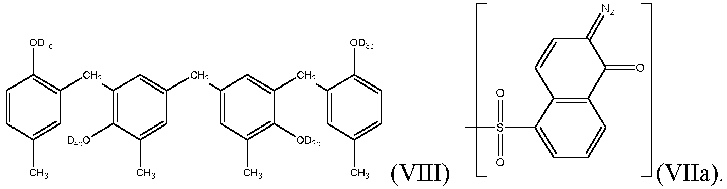

In other embodiments of the above inventive composition, wherein it comprises a free PAC, this PAC is either a single PAC compound or a mixture of PAC compounds having structure (VIII), wherein D_{1c}, D_{2c}, D_{3c} and D_{4c} are individually selected from H or a moiety having structure (VIIb), and further wherein at least one of D_{1c}, D_{2c}, D_{3c} or D_{4c} is a moiety having structure (VIIb):

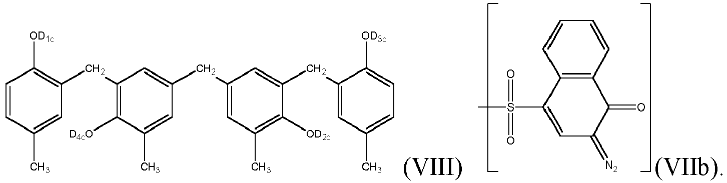

In other embodiments of the above inventive composition, wherein it comprises a free PAC, this PAC is either a single PAC compound or a mixture of PAC compounds having structure (VIIIa), wherein D_{1d}, D_{2d}, D_{3d}, and D_{4d} are individually selected from H or a moiety having structure (VIIa), and further wherein at least one of D_{1d}, D_{2d}, D_{3d} or D_{4d} is a moiety having structure (VIIa):

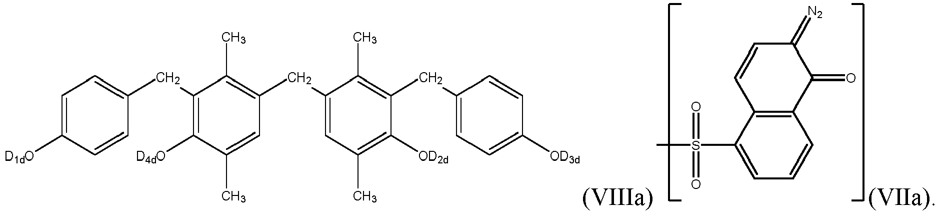

In other embodiments of the above inventive composition, wherein it comprises a free PAC, this PAC is either a single PAC compound or a mixture of PAC compounds having structure (VIIIa), wherein D_{1d}, D_{2d}, D_{3d}, and D_{4d} are individually selected from H or a moiety having structure (VIIb), and further wherein at least one of D_{1d}, D_{2d}, D_{3d} or D_{4d} is a moiety having structure (VIIb):

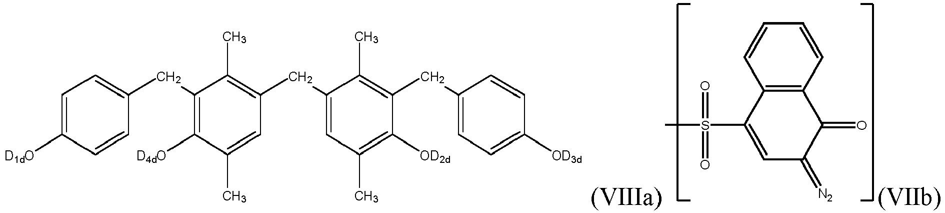

In other embodiments of the above inventive composition, wherein it comprises a free PAC component, this PAC component is either a single PAC compound or a mixture of PAC compounds having structure (VIIIb), wherein D₁ₑ, D₂ₑ, and D₃ₑ are individually selected from H or a moiety having structure (VIIa), and further wherein at least one of D₁ₑ, D₂ₑ, or D₃ₑ is a moiety having structure (VIIa):

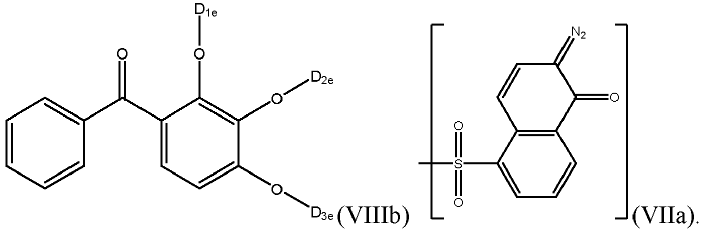

In other embodiments of the above inventive composition, wherein it comprises a free PAC, this PAC is either a single PAC compound or a mixture of PAC compounds having structure (VIIIb), wherein D₁ₑ, D₂ₑ, and D₃ₑ are individually selected from H or a moiety having structure (VIIb), and further wherein at least one of D₁ₑ, D₂ₑ, or D₃ₑ is a moiety having structure (VIIb):

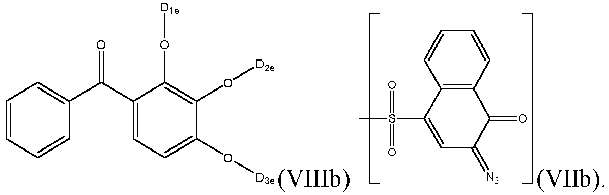

The mass ratio of the (C) PAC to the total mass of the solid components in the composition is typically approximately 12 to approximately 18 mass %.

### (D) Solvent

In the above described inventive composition, said solvent is an organic solvent. Examples of suitable organic solvents include, without limitation, butyl acetate, amyl acetate, cyclohexyl acetate, 3-methoxybutyl acetate, methyl ethyl ketone, methyl amyl ketone, cyclohexanone, cyclopentanone, ethyl-3-ethoxy propanoate, methyl-3-ethoxy propanoate, methyl-3-methoxy propanoate, methyl acetoacetate, ethyl acetoacetate, diacetone alcohol, methyl pivalate, ethyl pivalate, propylene glycol monomethyl ether, propylene glycol monoethyl ether, propylene glycol monomethyl ether propanoate, propylene glycol monoethyl ether propanoate, ethylene glycol monomethyl ether, ethylene glycol monoethyl ether, diethylene glycol monomethyl ether, diethylene glycol monoethyl ether, 3-methyl-3-methoxybutanol, N-methylpyrrolidone, dimethyl sulfoxide, gamma-butyrolactone, propylene glycol methyl ether acetate, propylene glycol ethyl ether acetate, propylene glycol propyl ether acetate, methyl lactate, ethyl lactate, propyl lactate, tetramethylene sulfone, propylene glycol dimethyl ether, dipropylene glycol dimethyl ether, ethylene glycol dimethyl ether or diethylene glycol dimethyl ether. These solvents may be used singly or in a mixture of two or more. Particular preference is given to propylene glycol methyl ether acetate (1-methoxy-2-propanyl acetate).

### Optional Components

### Heterocyclic Thiol Compound

In the above inventive composition, a heterocyclic thiol compound may be present, and is selected from mono or di thiol derivatives of an unsaturated heterocyclic compound comprising nitrogen, sulfur or a combination of these two atoms, as the heteroatoms in the heterocyclic compound. In another aspect said mono or di thiol derivative is a derivative of a triazole, diazole, imidazole and thiadiazole heterocycles. In another aspect said mono or di thiol derivative is a derivative of a triazine heterocycle. In another aspect said mono or di thiol derivative, is selected from the group consisting of ones having structure (IXa), (IXb), (IXc), (IXd), and (IXe).

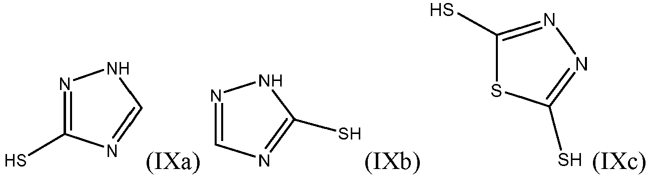

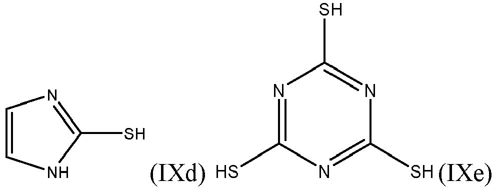

The mass ratio of the heterocyclic thiol compound to the total mass of the solid component in the composition is 0.11 -0.16 mass %.

### Base Component

The above inventive composition may contain a base compound. An exemplary base component is selected from an amine compound or a mixture of amine compounds having a boiling point above 100°C at atmospheric pressure, and a pKa of at least 1.

The base component may be at least selected from the group consisting of compounds having structures (Xa), (Xb), (Xc), (Xd), (Xe), (Xf),(Xg), (Xh), (Xi), (Xj) and (Xk); wherein R_{b1} is C₁₋₂₀ saturated alkyl chain or a C₂₋₂₀ unsaturated alkyl chain; R_{b2}, R_{b3}, R_{b4}, R_{b5}, R_{b6}, R_{b7}, R_{b8}, R_{b9}, R_{b10}, R_{b11}, R_{b12} and R_{b13}, are independently selected from the group consisting of H, and a C₁₋₂₀ alkyl.

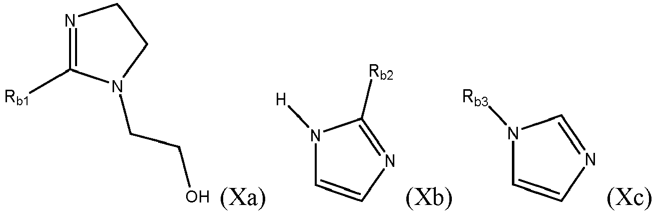

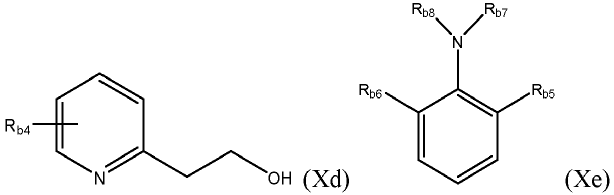

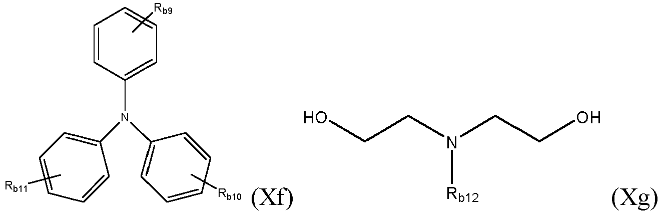

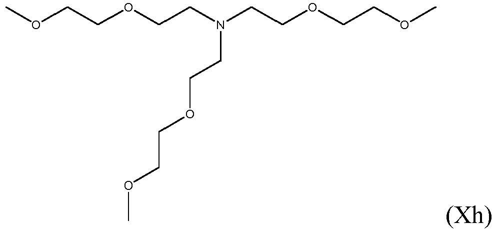

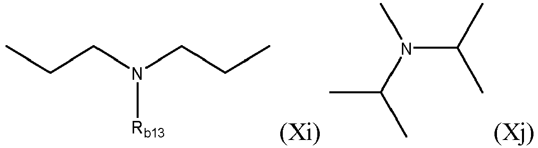

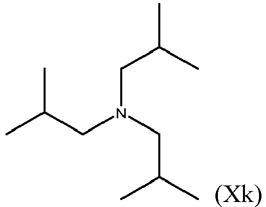

The mass ratio of the base component to the total mass of the solid component in the composition is approximately 0.11 to approximately 0.16 mass %.

### Other Optional Components

Other optional components, which have compatibility with and can be added to the inventive photoresist composition disclosed and claimed herein according to need, include auxiliary resins, plasticizers, surface leveling agents and stabilizers to improve the properties of the resist layer, and the like. Surface leveling agents may include surfactants. Generally, the amount of the other components is up to 3 mass%, preferably 1 mass%, based on the total mass of the composition. There is no particular restriction with regard to the surfactant, and the examples of it include a polyoxyethylene alkyl ether such as polyoxyethylene lauryl ether, polyoxyethylene stearyl ether, polyoxyethylene cetyl ether, and polyoxyethylene olein ether; a polyoxyethylene alkylaryl ether such as polyoxyethylene octylphenol ether and polyoxyethylene nonylphenol ether; a polyoxyethylene polyoxypropylene block copolymer; a sorbitane fatty acid ester such as sorbitane monolaurate, sorbitane monovalmitate, and sorbitane monostearate; a nonionic surfactant of a polyoxyethylene sorbitane fatty acid ester such as polyoxyethylene sorbitane monolaurate, polyoxyethylene sorbitane monopalmitate, polyoxyethylene sorbitane monostearate, polyethylene sorbitane trioleate, and polyoxyethylene sorbitane tristearate; a fluorinated surfactant such as F-Top EF301, EF303, and EF352 (manufactured by Jemco Inc.), Megafac F171, F172, F173, R08, R30, R90, and R94 (manufactured by Dainippon Ink & Chemicals, Inc.), Florad FC-430, FC-431, FC-4430, and FC-4432 (manufactured by Sumitomo 3M Ltd.), Asahi Guard AG710, Surflon S-381, S-382, S-386, SC101, SC102, SC103, SC104, SC105, SC106, Surfinol E1004, KH-10, KH-20, KH-30, and KH-40 (manufactured by Asahi Glass Co., Ltd.); an organosiloxane polymer such as KP-341, X-70-092, and X-70-093 (manufactured by Shin-Etsu Chemical Co., Ltd.); and an acrylic acid or a methacrylic acid polymer such as Polyflow No. 75 and No. 95 (manufactured by Kyoeisha Chemical Co. Ltd.).

### Process for Imaging a Resist

The present invention provides a process for imaging a resist comprising the steps;
i) coating the above-described composition above a substrate to form a resist film;
ii) selectively exposing said resist film to light using a mask to form a selectively exposed resist film; and
iii) developing said selectively exposed film to form a positively imaged resist film over said substrate.

The method for coating the composition above a substrate surface can be freely selected from known methods, such as spin coating, spray coating, roll coating, bar coating, doctor coating, slit coating, slit-and-spin coating, and the like. A silicon substrate, a metal substrate, a glass substrate, a resin film, can be used. A glass substrate with a silicon layer is suitable for a display application.

After forming a coating film of the composition according to the present invention, it is preferred to carry out pre-baking of the coating film in order to dry the coating film and reduce the residual amount of the solvent. The pre-baking process can be carried out to form a resist film, at a temperature of approximately 80 to approximately 120°C for approximately 30 to approximately 300 seconds. Proximity bake is preferable, that there is a space between a hot-plate and a substrate.

Subsequently, the resist film is selectively exposed to light through a mask. Irradiation light preferably comprises at least a wavelength of approximately 350 to approximately 440nm.

The selectively exposed resist film is developed with an alkaline aqueous solution to form a positively imaged resist film over the substrate. The alkaline aqueous solution can be freely selected from known compound solutions, such as an aqueous tetramethylammonium hydroxide solution, an aqueous trimethylammonium hydroxide solution, an aqueous potassium hydroxide solution, and the like. An aqueous tetramethylammonium hydroxide solution is preferable. Subsequently, the positively imaged resist film is rinsed with deionized water, cleaning solution and the like to remove a remaining developer.

PEB is not essential for a resist film derived from the composition according to the present invention.

### Manufacturing a Device

The substrate with the imaged resist of the above-described manufacturing method is further processed to produce a device. Such further processing can be done by using a known method. Preferably the device is a display device, solar cell device, organic light emitting diode device and inorganic light emitting diode device. Preferably, the device of this invention is a display device.

### EXAMPLES

Reference will now be made to more specific examples of the present disclosure and experimental results that provide support for the invention. However, Applicants note that the disclosure below is for illustrative purposes only and is not intended to limit the scope of the claimed subject matter in any way. The scope of the invention is defined by the claims.

Molecular weights in terms of polystyrene of polymers are measured with Gel Permeation Chromatography (GPC) using monodispersed polystyrene standards.

### Polymer Synthesis Example 1

A 250 mL round-bottom flask is charged with 11.8 g of poly-4-hydroxystyrene (Maruzen Petrochemical, Maruka lyncur M2VPM, Mw 12,000, Mw/Mn = 3, 30.0 mass % in PGMEA), 11.8 g Novolac resin (Asahi Yukizai CL16F90G, Mw 917, Mw 2930, Mw/Mn 3.19, Cresol, Xylenol Novolac) and further 23.76 g of PGMEA, followed by stirring to form a clear solution. 3.54 g (0.25 equivalents based on total amount of poly-4-hydroxystyrene/Novolac resin) of ethyl vinyl ether is then added to the solution with stirring, followed by adding 20 mg of p-toluenesulfonic acid monohydrate as catalyst. The reaction is conducted under room temperature for 24 hours in a closed system. The reaction is quenched by adding 36.5 mg of tris[2-(2-methoxyethoxy)ethyl]amine (TMEEA, 10.0 mass % in PGMEA, 1.1 equivalent to p-toluenesulfonic acid monohydrate) all at once. The resulting solution is one containing about 35.0% by mass of ethoxyethyl-protected poly-4-hydroxystyrene/Novolac resin. The resulting resin has a number average molecular weight (Mn) of 1,654 and a mass average molecular weight (Mw) of 7,332. A photoresist formulation is prepared by directly using the product as prepared.

### Example 1

A positive photoresist composition is prepared by dissolving 25% ethoxyethyl-protected poly-4-hydroxystyrene/Novolac resin 3.3151 g, synthesized by polymer synthesis Example 1, 2,3,4-trihydroxy benzophenone-2,1,5-diazonaphthoquinonesulfonate (PW1093) 0.5850 g, benzeneacetonitrile, 2-methyl-.alpha.-[2-[[(propylsulfonyl)oxy]imino]-3(2H)-thienylidene]- (CI103) 0.0544 g, trioctylamine (TOA) 0.0055 g, monazoline C (Mona C) 0.0090 g, and megface (R-2011) 0.0090 g in propyleneglycolmonomethylether acetate (PGMEA) 14.0275 g. The resulting solution is filtered through a 0.2µm PTFE (polytetrafluoroethylene) filter.

### Comparative Example 1

A positive photoresist composition is prepared by dissolving 30% ethoxyethyl-protected Novolac resin 3.3151 g, 2,3,4-trihydroxy benzophenone-2,1,5-diazonaphthoquinone sulfonate (PW1093) 0.5850 g, benzeneacetonitrile, 2-methyl-.alpha.-[2-[[(propylsulfonyl)oxy]imino]-3(2H)-thienylidene]- (CI103) 0.0544 g, trioctylamine (TOA) 0.0055 g, monazoline C (Mona C) 0.0036 g, and megface (R-2011) 0.0090 g in propyleneglycolmonomethylether acetate (PGMEA) 14.0275 g. The resulting solution is filtered through a 0.2µm PTFE filter.

### Lithographic Evaluation

A photoresist composition is spin coated on a 6" diameter Si wafer at an appropriate spin speed (1,000 - 2,000 rpm) to produce the desired film thickness. The coating film of the composition is prebaked on a contact hot plate at 90°C for 90 seconds. The resist film is then exposed to a masked pattern by using Ultratech g,h-line stepper. The exposed resist film is developed for 60 seconds puddle using standard AZ^{®} 300MIF developer (2.38% tetramethylammonium hydroxide aqueous solution). The developed resist film is then rinsed thoroughly with deionized water.

The resist pattern profile cross sections are examined by means of scanning electron microscopy. A Hitatchi SU8030 SEM is used to evaluate resist profiles.

The resist pattern is heat-treated at 135°C for 200 seconds to evaluate thermal stability.

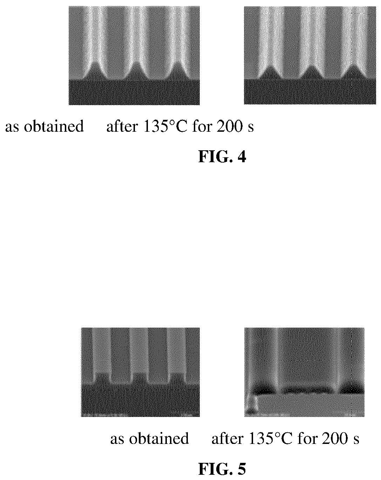

The pattern profile cross section and the thermal stability of the above-prepared positive photoresist composition are shown in Table 1. FIG. 4 illustrates SEM images obtained with Example 1. FIG. 5 illustrates SEM images obtained with Comparative Example 1.

**Table 1**

| | Cross section profile | Thermal stability (135°C for 200 s) |
|---|---|---|
| Example 1 | taper | shape maintained |
| Comparative Example 1 | T-topping | shape changed |

## Claims

1. A chemically amplified photoresist composition comprising (A) a polymer component, (B) a photoacid generator, (C) a photoactive diazonaphthoquinone compound, and (D) a solvent, wherein
(A) the polymer component is a mixture of (A-1) a Novolak derivative and (A-2) a polymer comprising hydroxystyrene repeat units; wherein
(A-1) the Novolak derivative comprises Novolak repeat units with free phenolic hydroxy moieties and phenolic hydroxy moieties protected with an acid cleavable acetal moiety; and
(A-2) the polymer comprising hydroxystyrene repeat units with free phenolic hydroxy moieties and phenolic hydroxy moieties protected with an acid cleavable acetal moiety.

2. The composition according to claim 1, wherein the acid cleavable acetal moiety is a group represented by formula (1): 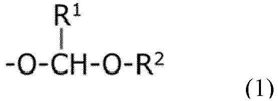 wherein, R¹ and R² represent each independently a C₁₋₄ alkyl.

3. The composition according to claims 1 or 2, wherein a mass ratio of the Novolak derivative to the polymer comprising hydroxystyrene repeat units is 76:24 to 64:36.

4. The composition according to claims 1 or 2, wherein a mass ratio of the Novolak derivative to the polymer comprising hydroxystyrene repeat units is 73:27 to 67:33.

5. The composition according to any one of claims 1 to 4, wherein a mole ratio of the phenolic hydroxy moieties protected with the acid cleavable acetal moiety to the total phenolic hydroxy moieties constituted in (A) the polymer component is 20 to 31 mol%.

6. The composition according to any one of claims 1 to 4, wherein a mole ratio of the phenolic hydroxy moieties protected with the acid cleavable acetal moiety to the total phenolic hydroxy moieties constituted in (A) the polymer component is 23 to 28 mol%.

7. The composition according to any one of claims 1 to 6, wherein the Novolak derivative is selected from the group consisting of a phenol-formaldehyde Novolak derivative, a cresolformaldehyde Novolak derivative and a xylenol-formaldehyde Novolak derivative.

8. The composition according to any one of claims 1 to 7, wherein the polymer comprising hydroxystyrene repeat units comprises a unit selected from the group consisting of a 4-hydroxystyrene unit, a 3- hydroxystyrene unit, a 2-hydroxystyrene unit and any mixture thereof.

9. The composition according to any one of claims 1 to 8, wherein the mass ratio of (A) the polymer component to the total mass of the composition is 15 to 22 mass %.

10. The composition according to any one of claims 1 to 9, wherein (B) the photoacid generator is at least selected from the group consisting of aromatic imide N-oxysulfonate derivatives of an organic sulfonic acid, an aromatic sulfonium salt of an organic sulfonic acid and trihalotriazine derivatives.

11. The composition according to any one of claims 1 to 10, wherein the mass ratio of the (B) the photoacid generator to the total mass of the solid components in the composition is 1.1 to 1.6 mass %.

12. The composition according to any one of claims 1 to 11, wherein (C) the photoactive diazonaphthoquinone compound is derived from a 1,2-diazonaphthoquinone-5-sulfonate compound or a 1,2-diazonaphthoquinone-4-sulfonate compound or a mixture thereof.

13. The composition of any one of claims 1 to 12, wherein (C) the photoactive diazonaphthoquinone compound is either a single photoactive diazonaphthoquinone compound or a mixture of photoactive diazonaphthoquinone compounds having structure (2), wherein D₁ₑ, D₂ₑ, and D₃ₑ are individually selected from H or a moiety having structure (3), and further wherein at least one of D₁ₑ, D₂ₑ, or D₃ₑ is a moiety having structure (3),

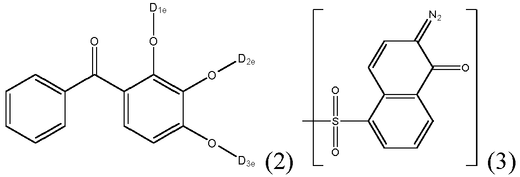

14. The composition according to any one of claims 1 to 13, wherein the mass ratio of the (C) the photoactive diazonaphthoquinone compound to the total mass of the solid component in the composition is 12 to 18 mass %.

15. The composition according to any one of claims 1 to 14, further comprising a base compound.

16. The composition according to claim 15, wherein the base component is selected from an amine compound or a mixture of amine compounds having a boiling point above 100°C, at atmospheric pressure, and a pKa of at least 1.

17. The composition according to claims 15 or 16, wherein the mass ratio of the base component to the total mass of the solid component in the composition is 0.11 to 0.16 mass %.

18. The composition according to any one of claims 1 to 17, further comprising a heterocyclic thiol compound.

19. The composition according to claim 18, wherein the heterocyclic thiol compound is selected from mono or di thiol derivatives of an unsaturated heterocyclic compound comprising nitrogen, sulfur or a combination of these two atoms, as the heteroatoms in the heterocyclic compound.

20. The composition according to any one of claims 1 to 19, wherein (A) the polymer component further comprises an acetal-group-crosslinked copolymer of (A-1) a Novolak derivative and (A-2) a polymer comprising hydroxystyrene repeat units; wherein
(A-1) the Novolak derivative comprises Novolak repeat units with free phenolic hydroxy moieties and phenolic hydroxy moieties protected with the acid cleavable acetal moiety; and
(A-2) the polymer comprising hydroxystyrene repeat units with free phenolic hydroxy moieties and phenolic hydroxy moieties protected with the acid cleavable acetal moiety.

21. A process for imaging a resist comprising the steps;
i) coating the composition of any one of claims 1 to 20 above a substrate to form a resist film;
ii) selectively exposing said resist film to light using a mask to form a selectively exposed resist film;
iii) developing said selectively exposed film to form a positively imaged resist film over said substrate.

22. A method for manufacturing a device, comprising a manufacturing method of imaging a resist on a substrate according to claim 21.

23. The use of the composition according to any one of claims 1 to 20 for coating a substrate.

## Patentansprüche

1. Chemisch verstärkte Fotolackzusammensetzung umfassend (A) eine Polymerkomponente, (B) einen Fotosäureerzeuger, (C) eine fotoaktive Diazonaphthochinonverbindung, und (D) ein Lösungsmittel, wobei
(A) die Polymerkomponente eine Mischung aus (A-1) einem Novolak-Derivat und (A-2) einem Polymer umfassend Hydroxystyrol-Wiederholungseinheiten ist, wobei
(A-1) das Novolak-Derivat Novolak-Wiederholungseinheiten mit freien phenolischen Hydroxygruppen und mit einer säurespaltbaren Acetalgruppe geschützten phenolischen Hydroxygruppen umfasst; und
(A-2) das Polymer umfassend Hydroxystyrol-Wiederholungseinheiten mit freien phenolischen Hydroxygruppen und mit einer säurespaltbaren Acetalgruppe geschützten phenolischen Hydroxygruppen.

2. Zusammensetzung gemäß Anspruch 1, wobei die säurespaltbare Acetalgruppe eine Gruppe dargestellt durch Formel (1) ist: 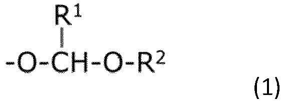 wobei R¹ und R² jeweils unabhängig C₁₋₄ Alkyl darstellen.

3. Zusammensetzung gemäß Ansprüchen 1 oder 2, wobei ein Massenverhältnis von dem Novolak-Derivat und dem Polymer umfassend Hydroxystyrol-Wiederholungseinheiten 76:24 bis 64:36 ist.

4. Zusammensetzung gemäß Ansprüchen 1 oder 2, wobei ein Massenverhältnis von dem Novolak-Derivat und dem Polymer umfassend Hydroxystyrol-Wiederholungseinheiten 73:27 bis 67:33 ist.

5. Zusammensetzung gemäß einem beliebigen der Ansprüche 1 bis 4, wobei ein Molverhältnis der mit der säurespaltbaren Acetalgruppe geschützten phenolischen Hydroxygruppen zu den gesamten phenolischen Hydroxygruppen, die sich in (A) der Polymerkomponente befinden, 20 bis 31 Mol% ist.

6. Zusammensetzung gemäß einem beliebigen der Ansprüche 1 bis 4, wobei ein Molverhältnis der mit der säurespaltbaren Acetalgruppe geschützten phenolischen Hydroxygruppen zu den gesamten phenolischen Hydroxygruppen, die sich in (A) der Polymerkomponente befinden, 23 bis 28 Mol% ist.

7. Zusammensetzung gemäß einem beliebigen der Ansprüche 1 bis 6, wobei das Novolak-Derivat ausgewählt ist aus der Gruppe bestehend aus einem Phenol-Formaldehyd Novolak-Derivat, einem Kresol-Formaldehyd Novolak-Derivat und einem Xylenol-Formaldehyd Novolak-Derivat.

8. Zusammensetzung gemäß einem beliebigen der Ansprüche 1 bis 7, wobei das Polymer umfassend Hydroxystyrol-Wiederholungseinheiten eine Einheit ausgewählt aus der Gruppe bestehend aus einer 4-Hydroxystyrol-Einheit, einer 3-Hydroxystyrol-Einheit, einer 2-Hydroxystyrol-Einheit und beliebiger Mischung davon umfasst.

9. Zusammensetzung gemäß einem beliebigen der Ansprüche 1 bis 8, wobei das Massenverhältnis von (A) der Polymerkomponente zu der Gesamtmasse der Zusammensetzung 15 bis 22 Massen-% ist.

10. Zusammensetzung gemäß einem beliebigen der Ansprüche 1 bis 9, wobei (B) der Fotosäureerzeuger mindestens ausgewählt ist aus der Gruppe bestehend aus aromatischen Imid N-Oxysulfonat-Derivaten einer organischen Sulfonsäure, einem aromatischen Sulfoniumsalz einer organischen Sulfonsäure und Trihalotriazin-Derivaten.

11. Zusammensetzung gemäß einem beliebigen der Ansprüche 1 bis 10, wobei das Massenverhältnis von (B) dem Fotosäureerzeuger zu der Gesamtmasse der festen Bestandteile in der Zusammensetzung 1,1 bis 1,6 Massen-% ist.

12. Zusammensetzung gemäß einem beliebigen der Ansprüche 1 bis 11, wobei (C) die fotoaktive Diazonaphthochinonverbindung abgeleitet von einer 1,2-Diazonaphthochinon-5-Sulfonatverbindung oder einer 1,2-Diazonaphthochinon-4-Sulfonatverbindung oder einer Mischung davon ist.

13. Zusammensetzung gemäß einem beliebigen der Ansprüche 1 bis 12, wobei (C) die fotoaktive Diazonaphthochinonverbindung entweder eine einzelne fotoaktive Diazonaphthochinonverbindung oder eine Mischung aus fotoaktiven Diazonaphthochinonverbindungen der Struktur (2) ist, wobei D₁ₑ, D₂ₑ und D₃ₑ individuell ausgewählt sind aus H oder einer Gruppe der Struktur (3), und ferner wobei mindestens eines von D₁ₑ, D₂ₑ und D₃ₑ eine Gruppe der Struktur (3) ist,

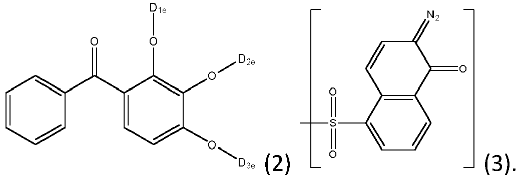

14. Zusammensetzung gemäß einem beliebigen der Ansprüche 1 bis 13, wobei das Massenverhältnis von (C) der fotoaktiven Diazonaphthochinonverbindung zu der Gesamtmasse des festen Bestandteils in der Zuammensetzung 12 bis 18 Massen-% ist.

15. Zusammensetzung gemäß einem beliebigen der Ansprüche 1 bis 14, ferner umfassend eine Basen-Verbindung

16. Zusammensetzung gemäß Anspruch 15, wobei die Basen-Verbindung ausgewählt ist aus einer Aminverbindung oder einer Mischung von Aminverbindungen mit einem Siedepunkt über 100 °C bei atmosphärischem Druck und einem pKa von mindestens 1.

17. Zusammensetzung gemäß Ansprüchen 15 oder 16, wobei das Massenverhältnis von der Basen-Verbindung zu der Gesamtmasse des festen Bestandteils in der Zusammensetzung 0,11 bis 0,16 Massen-% ist.

18. Zusammensetzung gemäß einem beliebigen der Ansprüche 1 bis 17, ferner umfassend eine heterozyklische Thiolverbindung.

19. Zusammensetzung gemäß Anspruch 18, wobei die heterozyklische Thiolverbindung ausgewählt ist aus Mono- oder Dithiolderivaten einer ungesättigten heterozyklischen Verbindung umfassend Stickstoff, Schwefel oder eine Kombination dieser zwei Atome, als Heteroatome in der heterozyklischen Verbindung.

20. Zusammensetzung gemäß einem beliebigen der Ansprüche 1 bis 19, wobei (A) die Polymerkomponente ferner ein Acetal-Gruppen-vernetztes Copolymer von (A1) einem Novolak-Derivat und (A-2) einem Polymer umfassend Hydroxystyrol-Wiederholungseinheiten umfasst, wobei
(A-1) das Novolak-Derivat Novolak-Wiederholungseinheiten mit freien phenolischen Hydroxygruppen und mit einer säurespaltbaren Acetalgruppe geschützten phenolischen Hydroxygruppen umfasst; und
(A-2) das Polymer umfassend Hydroxystyrol-Wiederholungseinheiten mit freien phenolischen Hydroxygruppen und mit einer säurespaltbaren Acetalgruppe geschützten phenolischen Hydroxygruppen.

21. Verfahren zum Abbilden eines Resists umfassend die Schritte:
i) Aufbringen der Zusammensetzung gemäß einem beliebigen der Ansprüche 1 bis 20 über ein Substrat, um einen Resistfilm zu bilden;
ii) selektiv Belichten des Resistfilms mit Licht unter Verwendung einer Maske, um einen selektiv belichteten Resistfilm zu bilden;
iii) Entwickeln des selektiv belichteten Resistfilms, um einen positiv abgebildeten Resistfilm über dem Substrat zu bilden.

22. Verfahren zur Herstellung einer Vorrichtung, umfassend ein Herstellungsverfahren zum Abbilden eines Resists auf einem Substrat gemäß Anspruch 21.

23. Verwendung der Zusammensetzung gemäß einem beliebigen der Ansprüche 1 bis 20 zum Beschichten eines Substrats.

## Revendications

1. Composition de photorésine chimiquement amplifiée comprenant (A) un composant de type polymère, (B) un générateur de photoacide, (C) un composé de type diazonaphtoquinone photoactif et (D) un solvant,
(A) le composant de type polymère étant un mélange de (A-1) un dérivé de novolaque et (A-2) un polymère comprenant des motifs répétitifs d'hydroxystyrène ;
(A-1) le dérivé de novolaque comprenant des motifs répétitifs de novolaque comportant des groupements hydroxy phénoliques libres et des groupements hydroxy phénoliques protégés par un groupement acétal clivable par un acide ; et
(A-2) le polymère comprenant des motifs répétitifs d'hydroxystyrène comportant des groupements hydroxy phénoliques libres et des groupements hydroxy phénoliques protégés par un groupement acétal clivable par un acide.

2. Composition selon la revendication 1, le groupement acétal clivable par un acide étant un groupe représenté par la formule (1) : 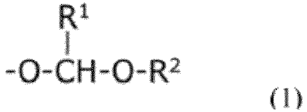 R¹ et R² représentant chacun indépendamment un alkyle en C₁₋₄.

3. Composition selon les revendications 1 ou 2, un rapport en masse du dérivé de novolaque sur le polymère comprenant des motifs répétitifs d'hydroxystyrène étant de 76 : 24 à 64 : 36.

4. Composition selon les revendications 1 ou 2, un rapport en masse du dérivé de novolaque sur le polymère comprenant des motifs répétitifs d'hydroxystyrène étant de 73 : 27 à 67 : 33.

5. Composition selon l'une quelconque des revendications 1 à 4, un rapport molaire des groupements hydroxy phénoliques protégés par le groupement acétal clivable par un acide sur les groupements hydroxy phénoliques totaux constitués dans (A) le composant de type polymère étant de 20 à 31 % en moles.

6. Composition selon l'une quelconque des revendications 1 à 4, un rapport molaire des groupements hydroxy phénoliques protégés par le groupement acétal clivable par un acide sur les groupements hydroxy phénoliques totaux constitués dans (A) le composant de type polymère étant de 23 à 28 % en moles.

7. Composition selon l'une quelconque des revendications 1 à 6, le dérivé de novolaque étant choisi dans le groupe constitué par un dérivé de novolaque de phénol-formaldéhyde, un dérivé de novolaque de crésol-formaldéhyde et un dérivé de novolaque de xylénol-formaldéhyde.

8. Composition selon l'une quelconque des revendications 1 à 7, le polymère comprenant des motifs répétitifs d'hydroxystyrène comprenant un motif choisi dans le groupe constitué par un motif 4-hydroxystyrène, un motif 3-hydroxystyrène, un motif 2-hydroxystyrène et un quelconque mélange correspondant.

9. Composition selon l'une quelconque des revendications 1 à 8, le rapport en masse de (A) le composant de type polymère sur la masse totale de la composition étant de 15 à 22 % en masse.

10. Composition selon l'une quelconque des revendications 1 à 9, (B) le générateur de photoacide étant au moins choisi dans le groupe constitué par des dérivés d'imide N-oxysulfonate aromatique d'un acide sulfonique organique, un sel de sulfonium aromatique d'un acide sulfonique organique et des dérivés de trihalogénotriazine.

11. Composition selon l'une quelconque des revendications 1 à 10, le rapport en masse du (B) le générateur de photoacide sur la masse totale des composants solides dans la composition étant de 1,1 à 1,6 % en masse.

12. Composition selon l'une quelconque des revendications 1 à 11, (C) le composé de type diazonaphtoquinone photoactif étant issu d'un composé de type 1,2-diazonaphtoquinone-5-sulfonate ou un composé de type 1,2-diazonaphtoquinone-4-sulfonate ou un mélange correspondant.

13. Composition selon l'une quelconque des revendications 1 à 12, (C) le composé de type diazonaphtoquinone photoactif étant soit un unique composé de type diazonaphtoquinone photoactif, soit un mélange de composés de type diazonaphtoquinone photoactifs ayant une structure (2), D₁ₑ, D₂ₑ et D₃ₑ étant individuellement choisis parmi H et un groupement ayant une structure (3) et en outre au moins l'un parmi D₁ₑ, D₂ₑ et D₃ₑ étant un groupement ayant une structure (3),

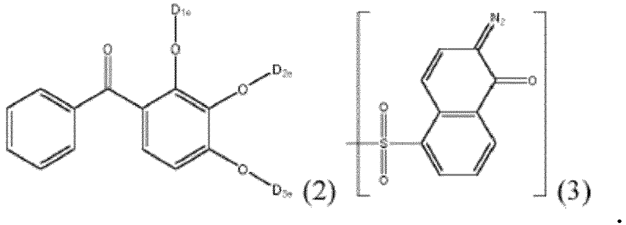

14. Composition selon l'une quelconque des revendications 1 à 13, le rapport en masse du (C) le composé de type diazonaphtoquinone photoactif sur la masse totale du composant solide dans la composition étant de 12 à 18 % en masse.

15. Composition selon l'une quelconque des revendications 1 à 14, comprenant en outre un composé de type base.

16. Composition selon la revendication 15, le composant de type base étant choisi parmi un composé de type amine et un mélange de composés de type amine ayant un point d'ébullition supérieur à 100 °C, à pression atmosphérique, et un pKa d'au moins 1.

17. Composition selon les revendications 15 ou 16, le rapport en masse du composant de type base sur la masse totale du composant solide dans la composition étant de 0,11 à 0,16 % en masse.

18. Composition selon l'une quelconque des revendications 1 à 17, comprenant en outre un composé de type thiol hétérocyclique.

19. Composition selon la revendication 18, le composé de type thiol hétérocyclique étant choisi parmi des dérivés de type monothiol ou dithiol d'un composé hétérocyclique insaturé comprenant de l'azote, du soufre ou une combinaison de ces deux atomes, en tant que les hétéroatomes dans le composé hétérocyclique.

20. Composition selon l'une quelconque des revendications 1 à 19, (A) le composant de type polymère comprenant en outre un copolymère réticulé par un groupe acétal de (A-1) un dérivé de novolaque et (A-2) un polymère comprenant des motifs répétitifs d'hydroxystyrène ;
(A-1) le dérivé de novolaque comprenant des motifs répétitifs de novolaque comportant des groupements hydroxy phénoliques libres et des groupements hydroxy phénoliques protégés par le groupement acétal clivable par un acide ; et
(A-2) le polymère comprenant des motifs répétitifs d'hydroxystyrène comportant des groupements hydroxy phénoliques libres et des groupements hydroxy phénoliques protégés par le groupement acétal clivable par un acide.

21. Procédé pour l'imagerie d'une résine comprenant les étapes :
i) revêtement de la composition selon l'une quelconque des revendications 1 à 20 au-dessus d'un substrat pour former un film de résine ;
ii) exposition de manière sélective dudit film de résine à de la lumière en utilisant un masque pour former un film de résine sélectivement exposé ;
iii) développement dudit film sélectivement exposé pour former un film de résine ayant une image positive sur ledit substrat.

22. Procédé pour la fabrication d'un dispositif, comprenant un procédé de fabrication d'imagerie d'une résine sur un substrat selon la revendication 21.

23. Utilisation de la composition selon l'une quelconque des revendications 1 à 20 pour le revêtement d'un substrat.
